# EUROPÄISCHE PATENTSCHRIFT

(11) **EP 1 263 141 B1**
(45) Veröffentlichungstag und Bekanntmachung des Hinweises auf die Patenterteilung: **16.04.2008**
(21) Anmeldenummer: 02009731.7
(22) Anmeldetag: 30.04.2002
(51) Int. Cl.: H03K 17/94, H03K 17/96

(54) **Schaltungsanordnung für mehrere Sensorelemente**
Switching arrangement for a plurality of sensor elements
Circuit de commutation pour plusieurs éléments de détection

(30) Priorität: 30.05.2001 DE 10127595
(43) Veröffentlichungstag der Anmeldung: 04.12.2002
(73) Patentinhaber: E.G.O. ELEKTRO-GERÄTEBAU GmbH, 75038 Oberderdingen (DE)
(72) Erfinder: Gremm, Oliver, 75057 Kürnbach (DE)
(74) Vertreter: Patentanwälte Ruff, Wilhelm, Beier, Dauster & Partner

(56) Entgegenhaltungen:
- EP-A- 0 802 500
- EP-A- 0 859 468
- US-A- 4 758 735
- US-A- 5 087 825

## Beschreibung

### Anwendungsgebiet und Stand der Technik

Die Erfindung betrifft eine Schaltungsanordnung für mehrere Sensorelemente gemäss dem Oberbegriff des Anspruchs 1.

Schaltungsanordnungen für mehrere Sensorelemente sind bekannt aus dem Stand der Technik, beispielsweise aus der EP 859 468. Darin sind die Sensorelemente dauernd mit der Ansteuerung verbunden bzw. das Ansteuersignal liegt dauernd an. Ebenso sind sie ständig mit der Auswertung verbunden, wobei die Auswertung einzelner Sensorelemente über einen Multiplexer erfolgt. Somit ist diese Schaltungsanordnung mit einem gewissen Aufwand verbunden, der aufgrund der entstehenden Kosten eine weitreichende Verbreitung von Berührungsschaltern beeinträchtigt.

Eine weitere, derartige Schaltungsanordnung ist aus der EP 802 500 bekannt, welche beispielsweise in Figur 4 und Figur 6 eine Anordnung mehrerer Sensorelemente mit Berührungsschaltern beschreibt. Diese sind über Selektoren mit einem gemeinsamen Signalausgang verbunden, wobei auch Transistoren zur Signalverarbeitung verwendet werden. Dabei sind alle Sensorelemente mit einer Auswerteschaltung verbunden, nicht benötigte Sensorelemente werden kurzgeschlossen.

Aus dem Dokument US 5 087 825 A ist eine Schaltungsanordnung gemäss dem Oberbegriff des Anspruchs 1 bekannt.

### Aufgabe und Lösung

Es ist Aufgabe der Erfindung, eine oben beschriebene Schaltungsanordnung für mehrere Sensorelemente zu schaffen, die schaltungstechnisch vereinfacht ist bzw. mit geringerem Bauteilaufwand zu realisieren ist und eine zuverlässige Funktion gewährleistet.

Diese Aufgabe wird gelöst durch eine Schaltungsanordnung mit den Merkmalen des Anspruchs 1. Vorteilhafte und bevorzugte Ausgestaltungen der Erfindung sind Gegenstand der weiteren Ansprüche und werden im folgenden näher beschrieben. Der Wortlaut der Ansprüche wird durch ausdrückliche Bezugnahme zum Inhalt der Beschreibung gemacht.

Erfindungsgemäß sind Verbindungsmittel bzw. Verbindungsschaltmittel vorgesehen, mit denen ein Sensorelement mit dem Auswerteteil zur Auswertung seines Betätigungszustandes verbunden bzw. zusammengeschaltet werden kann. Diese Verbindung bzw. Zusammenschaltung kann wählbar sein, um so eine Anpassung an verschiedene Gegebenheiten sowie die Anzahl der Sensorelemente zu erhalten. Besonders bevorzugt ist dann jeweils ein Sensorelement mit dem Auswerteteil verbunden, so dass das Auswerteteil sehr einfach gehalten sein kann. Auf diese Weise kann auf aufwändige Bauteile bzw. einen Multiplexer, wie in der oben erwähnten EP 859 468 enthalten, verzichtet werden.

Als Verbindungsmittel können allgemein Halbleiterbauelemente verwendet werden. Gemäß einer Möglichkeit können es in einer besonders einfachen Version Dioden sein. Vorteilhaft jedoch sind es Schaltmittel bzw. steuerbare, insbesondere elektronisch steuerbare, Schalter. Hierfür bieten sich besonders Transistoren an.

Die Verbindungsmittel können vorteilhaft über ein Signal, vorzugsweise ein getaktetes Signal, ansteuerbar sein. Eine Taktung kann derart ausgestaltet sein, dass jeweils nur ein Sensorelement gleichzeitig über die Verbindungsmittel mit dem Auswerteteil verbunden ist. In weiterer Ausgestaltung der Erfindung kann pro Sensorelement jeweils ein Verbindungsschaltmittel vorgesehen sein. Dadurch kann die Schaltung vereinfacht werden.

Gemäss einer Ausgestaltungsmöglichkeit der Erfindung kann das Ansteuersignal ständig an den Sensorelementen anliegen bzw. diese mit dem Ansteuersignal verbunden sein.

Bei einer anderen, bevorzugten Ausgestaltungsmöglichkeit können die Sensorelemente mittels Verbindungsmitteln mit dem Ansteuersignal verbunden werden. Bevorzugt sind dies dieselben Verbindungsmittel, die zur Verbindung mit dem Auswerteteil verwendet werden.

Ein Auswerteteil einer Schaltungsanordnung ist erfindungsgemäß derart ausgeführt, dass er einen Kondensator und einen Transistor aufweist. Der Kollektor des Transistors ist über den Kondensator mit Masse verbunden. Der Emitter ist mit dem Ansteuersignal verbunden. Die Transistorbasis wiederum ist über eine Diode und einen Widerstand mit einem Ansteuersignal verbunden. Erfindungsgemäß stellt sich im Betrieb der Schaltung über den Widerstand und die Diode bei einem unbetätigten Sensorelement, das mit dem Auswerteteil verbunden ist, ein Gleichgewicht zwischen Basis und Emitter ein. Dieses sollte ein Spannungsgleichgewicht sein. Des weiteren ist vorteilhaft der Auswerteteil mit einem Controller zum Auswerten des Signals verbunden, so dass in Abhängigkeit davon ein Schaltvorgang oder eine Zustandsänderung herbeigeführt werden kann.

Bei einer Betätigung des Sensorelements kann bei einer vorerwähnten Ausführung das Gleichgewicht zwischen Transistorbasis und Emitter verändert werden. Daraufhin öffnet der Transistor stärker und der Kondensator kann auf einen höheren Spannungswert aufgeladen werden. In einem solchen Fall arbeitet der Transistor vorteilhaft als über seine Basis steuerbarer Widerstand. Dieser erhöhte Spannungswert kann über eine einfache Folgeschaltung ausgewertet werden, da die Signaländerung relativ hoch gewählt werden kann.

Die Sensorelemente der Schaltungsanordnung können in eigenen Sensorzweigen enthalten sein. Ein Sensorzweig kann jeweils einen Ansteuerpunkt und einen Masseschluss enthalten. Dabei kann der Ansteuerpunkt mit dem Ansteuersignal bzw. der Ansteuerschaltung und gleichzeitig der Auswerteschaltung verbunden sein. Die Verbindungsschaltmittel sind vorzugsweise in dem Sensorzweig enthalten. Insbesondere ist auch eine zu den Verbindungsschaltmitteln zugehörige Ansteuerung in jedem Sensorzweig enthalten bzw. separat dafür vorgesehen.

Durch den vereinfachten Aufbau der Schaltung nach der Erfindung ist es möglich, die Sensorelemente weiter auseinander zu legen bei gleichzeitig sehr gutem Signalhub. Dafür sind keine Analogschalterbausteine notwendig. Des weiteren kann der Signalhub der Schaltung so groß gewählt werden, dass es möglich ist, ohne Verstärker ein Signal eines Sensorelements auszuwerten. Mit einem Minimum an Bauteilen können mehrere bzw. viele Sensorelemente betrieben werden. Über die Verbindungsschaltmittel kann eine Art Multiplexung erfolgen, allerdings auf schaltungstechnisch sehr einfache und überzeugende Art.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer allgemeinen Gültigkeit.

### Kurzbeschreibung der Zeichnungen

Mehrere Ausführungsbeispiele der Erfindung sind in den Zeichnungen dargestellt und werden im folgenden näher erläutert. In den Zeichnungen zeigen:
- Fig. 1: eine grundlegende Variante einer Schaltungsanordnung, bei der Transistoren als Verbindungsschaltmittel eingesetzt sind,
- Fig. 2: eine Schaltungsanordnung ähnlich Fig. 1, bei der die Dioden als Verbindungsmittel eingesetzt sind,
- Fig. 3: eine weitere Variante der Schaltungsanordnung und
- Fig. 4-7: Abwandlungen der Schaltungsanordnung aus Fig. 3.

### Detaillierte Beschreibung der Ausführungsbeispiele

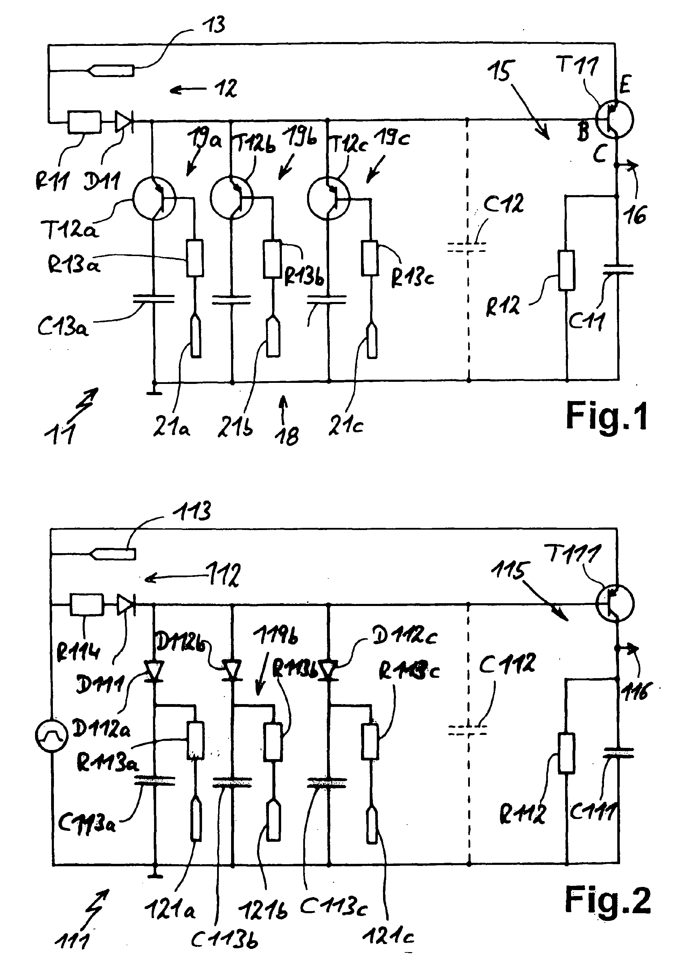

Die Fig. 1 zeigt eine Schaltungsanordnung 11, die beispielhaft für die Auswertung von drei kapazitiven Berührungsschaltern ausgelegt ist. Selbstverständlich könnten damit in einfacher Abwandlung weitere Berührungsschalter betrieben werden. Ein Ansteuerteil 12 der Schaltung 11 weist eine Signalquelle 13 mit einem Ansteuersignal auf. Das Ansteuersignal ist vorzugsweise ein Wechselspannungssignal oder ein unipolares Rechtecksignal. Des weiteren sind ein Widerstand R11 und eine Diode D11 in dem Ansteuerteil 12 vorhanden.

Der Auswerteteil 15 weist einen Transistor T11 auf, dessen Emitter E mit der Signalquelle 13 verbunden ist. Die Basis B ist mit der Diode D11 verbunden. Der Kollektor C von T11 ist über eine Parallelschaltung eines Kondensators C11 und eines Widerstandes R12 gegen das Grundpotential der Schaltung bzw. Masse gelegt. Über einen Ausgang 16 kann das Ausgangssignal abgegriffen werden, das als analoges Signal am Kondensator C11 anliegt.

Der Kondensator C12 stellt eine Störgrösse in der Schaltung dar und kann bei einer Schaltung für ein homogenes Ausgangssignal bestückt werden. An sich gilt es, eine solche Störgrösse zu vermeiden, aber durch Bestückung kann dennoch die einwandfreie Funktion der Schaltung sichergestellt werden. Ein beispielhafter Wert für C12 liegt im Bereich von 10pF. Ebenso sind eine R-Störgrösse oder eine RC-Störgrösse möglich.

Der Sensorteil 18 der Schaltungsanordnung 11 umfasst mehrere sogenannte Sensorzweige 19, die jeweils einen kapazitiven Berührungsschalter C13 a-c aufweisen. Diese sind durch einen Kondensator dargestellt. Als kapazitive Berührungsschalter können grundsätzlich alle Typen eingesetzt werden, besonders bevorzugt sind solche, wie sie in der EP 98101516 beschrieben sind.

Des weiteren weisen die Sensorzweige 19 Verbindungsschaltmittel in Form von Transistoren T12 a-c auf. Deren Funktion besteht darin, die Berührungsschalter C13 mit dem Ansteuerteil 12 und dem Auswerteteil 15 zu verbinden. Angesteuert werden die Transistoren T12 a-c über Verbindungs-Schaltsignale 21 und Vorwiderstände 22. Die Verbindungs-Schaltsignale 21 sind dabei so gewählt, dass zu jedem Zeitpunkt jeweils nur ein Sensorzweig 19 am Ansteuerteil 12 und am Auswerteteil 15 liegt.

### Funktion der Schaltung in Fig. 1

Im Folgenden wird die grundsätzliche Funktion der Schaltung in Fig. 1 beschrieben. Diese Funktionsbeschreibung gilt allgemein auch für die anderen Schaltungen in Fig. 2 bis 7. Eventuelle Abweichungen werden jeweils erläutert.

Die Signalquelle 13 zur Ansteuerung liefert ein Ansteuersignal, das am Emitter E von T11 und über den Diodenzweig an der Basis B von T11 anliegt. Über die Verbindungs-Schaltsignale 21 werden in automatischer, vorgegebener Reihenfolge einzelne Sensorzweige 19 und damit Sensorelemente C13 an die Schaltung angeschlossen. Beispielhaft wird im folgenden von dem Fall ausgegangen, dass der Sensorzweig 19a über den angesteuerten Transistor T12a angeschlossen ist. Wenn der Berührungsschalter C13 a nicht betätigt wird, liegt über die Diode D11 eine Gleichschaltung zwischen Emitter E und Basis B von T11 vor.

Wird nun der Berührungsschalter C13 a betätigt, führt dies dazu, dass sich eine Spannungs- und Laufzeitänderung an der Basis B gegenüber dem Emitter E von T11 einstellt. Dadurch öffnet der Transistor T11 mehr und der Auswerte-Kondensator C11 wird auf einen höheren Spannungswert aufgeladen. Hier arbeitet T11 als über seine Basis gesteuerter veränderlicher Widerstand. Am Kondensator C11 kann über den Ausgang 16 das Ausgangssignal entnommen werden. Es kann beispielsweise von einem Controller oder dergleichen ausgewertet werden. Ein solches Auswerteverfahren ist in der o.g. europäischen Patentanmeldung beschrieben. Beim Öffnen des Transistors T11 wird C11 aufgeladen. Über den Widerstand R12 kann C11 wieder entladen werden, wenn das Ansteuersignal der Signalquelle 13 Null ist.

Durch die nacheinander folgende Verbindung bzw. Ankoppelung jeweils eines Sensorzweiges 19 an die Ansteuer- und Auswerteschaltung erfolgt eine Art getakteter Abfrage der einzelnen Sensorzweige 19. Auf diese Weise kann eine sehr einfache Ansteuerung mehrerer Sensorelemente C13 erfolgen. Deren Schaltzustand wird durch die Verbindungs-Schaltsignale 21 nacheinander bzw. getaktet abgefragt.

### Beschreibung der übrigen Schaltungsbeispiele

Die Fig. 2 zeigt eine geringfügige Abwandlung der Schaltung aus Fig. 1, wobei die als frei schaltbare Transistoren ausgebildeten Verbindungsschaltmittel T12 durch Verbindungsmittel in Form der Dioden D12 ersetzt worden sind. Durch entsprechende Wahl der Verbindungs-Schaltsignale kann auf genau dieselbe Art und Weise wie bei der Schaltung in Fig. 1 jeweils ein Sensorzweig 119 an die restliche Schaltung angeschlossen werden.

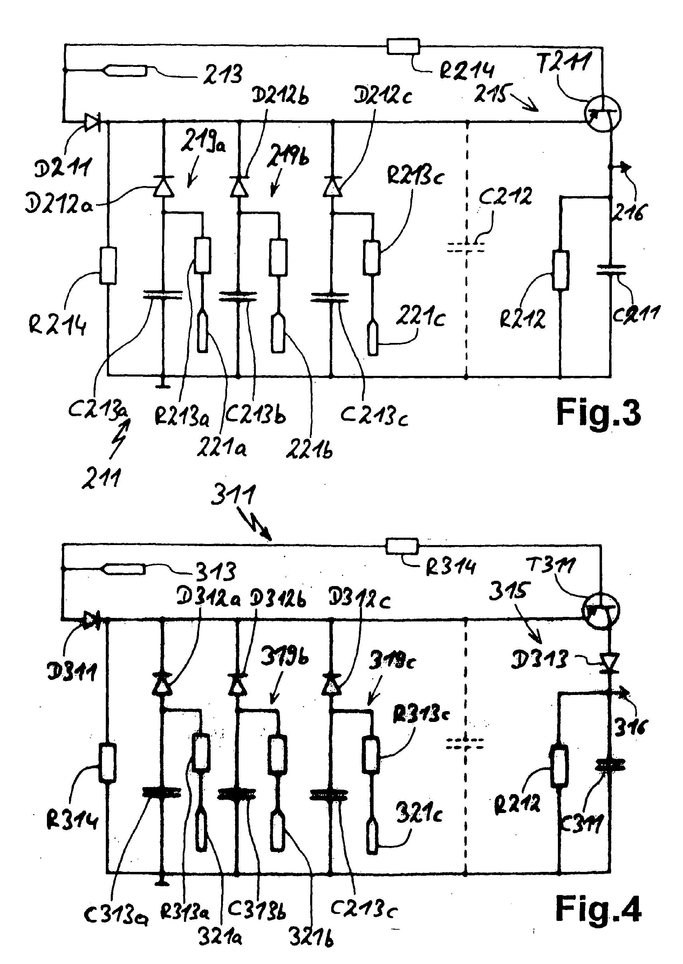

Die Schaltung 211 in Fig. 3 ist eine weitere Abwandlung. Der grundsätzliche Aufbau mit Ansteuerteil 212, Auswerteteil 215 und den Sensorzweigen 219 ist auch hier vorhanden. Beispielhaft sind drei Sensorzweige 319 a-c dargestellt, es können jedoch auch beliebig mehr sein. In Abwandlung sitzt der Widerstand R214 zwischen Signalquelle 213 und der Basis B des Transistors T211. Der Emitter E ist über die Diode D211 mit dem Ansteuersignal 213 verbunden.

Die Sensorzweige 219 a-c sind im wesentlichen entsprechend wie bei Fig. 2 ausgeführt, allerdings sind die Dioden entgegengesetzt geschaltet. Des weiteren ist ein Widerstand R214 vorgesehen, der parallel zu den Sensorzweigen 219 liegt. Dieser Widerstand R214 arbeitet als Ableitwiderstand und entlädt zum einen die Sensorelemente C213. Zum anderen macht er die Dioden D212 leitend.

### Funktion der Schaltungsanordnung in Fig. 3

Im folgenden wird grundsätzlich die Funktion der Schaltungsanordnung gemäß Fig. 3 beschrieben. Dies gilt auch für die weiteren Abwandlungen dieser Schaltung in den Fig. 4 bis 7.

Die Signalquelle 213 liefert ein Wechselspannungs- oder unipolares Rechtecksignal, welches über den Widerstand R214 an die Basis B von T211 gegeben wird. Des weiteren liegt über die Diode D211 das Ansteuersignal am Emitter E von T211 an. Während der Zeit, während der das Ansteuersignal größer als 0,7V ist, wird im Fall einer betätigten Sensorelementkapazität C213 diese auf den Wert (Ansteuersignal - 0,7V) aufgeladen. In dieser Zeit ist der Transistor T211 gesperrt, um den Bereich des Auswerteteils 215 mit Ausgang 216 und Kondensator 211 abzutrennen.

Zu dem Zeitpunkt, zu dem die Eingangsspannung des Ansteuersignals 213 unter die Spannung am Emitter E von T211 fällt, sperrt die jeweilige Diode D212, der Transistor T211 öffnet und überträgt die Spannung am Sensorelement 213 auf den Kondensator C211 des Auswerteteils. Wie zuvor beschrieben, kann so am Ausgang 216 das analoge Ausgangssignal abgegriffen werden. Aus diesem Ausgangssignal kann dann eine Betätigung abgelesen werden. Hierbei ist zu beachten, dass über die Verbindungs-Schaltsignale 221 und den Widerstand R214 jeweils nur genau eine Diode 212 leitend gemacht wird und somit diesen Sensorzweig 219 an die übrige Schaltung verbindet.

### Beschreibung der Ausführungsbeispiele gemäß Fig. 4 bis 7

Die Schaltung nach Fig. 4 entspricht der Schaltung aus Fig. 3. Hier ist lediglich zusätzlich eine Diode D313 zwischen Kollektor C von T311 und dem Parallelzweig von Kondensator T311 und R312 vorgesehen. Diese Diode vermeidet einen Leckstrom zwischen D311 und dem Transistor T311.

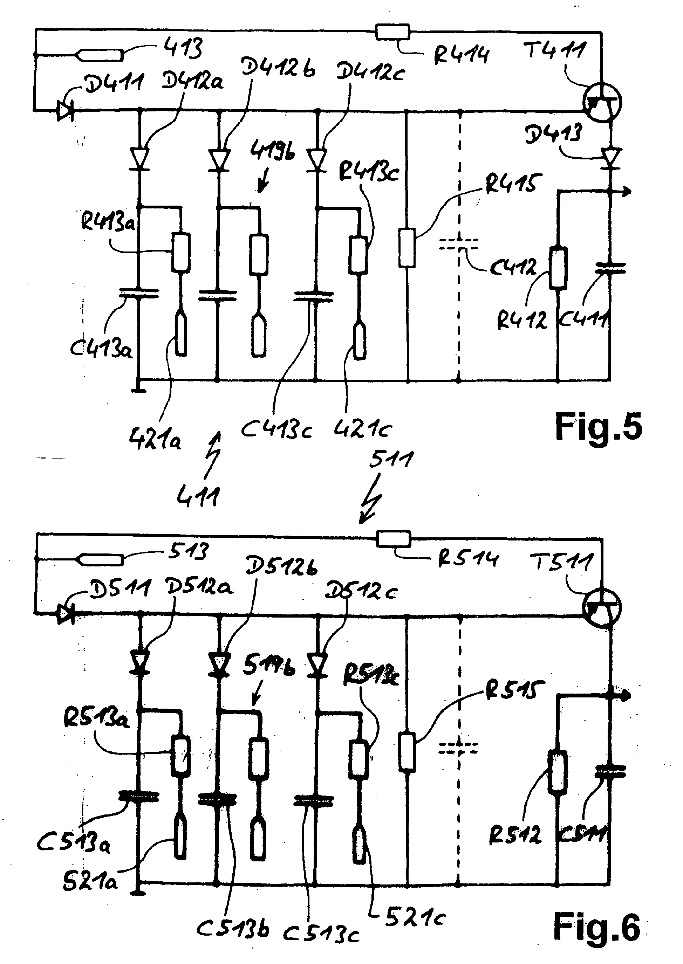

Die Schaltung in Fig. 5 entspricht derjenigen aus Fig. 4. Allerdings sind hier die Dioden D412 wieder umgedreht. Der Widerstand R415 kann eine weitere mögliche Störgröße symbolisieren.

Die Schaltung in Fig. 6 entspricht der Schaltung in Fig. 5, wobei hier beispielhaft die Diode 413 aus Fig. 5 weggelassen worden ist.

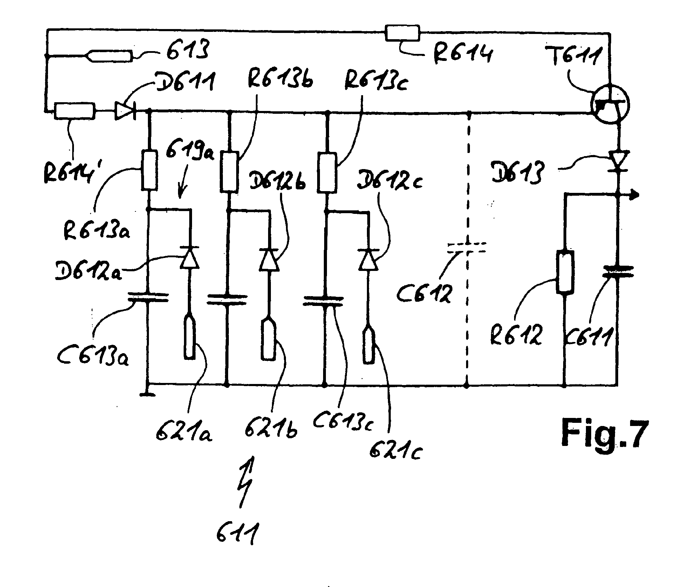

Die Schaltung in Fig. 7 entspricht im wesentlichen der Schaltung in Fig. 4. Hier ist der Widerstand R614' zwischen Ansteuersignalquelle 613 und Diode D611 eingefügt. Ein dem Widerstand R314 der Figur 4 entsprechender Widerstand fehlt.

Eine weitere grundsätzliche Abwandlung der Schaltung gem. Fig. 7 kann darin bestehen, dass im Gegensatz zu Fig. 4 die Dioden D612 und die Widerstände R613 vertauscht sind. Damit sitzen die Dioden D612 direkt an der Quelle der Verbindungs-Schaltsignale 621.

Eine weitere, nicht dargestellte Abwandlung der Schaltung aus Fig. 7 ist dermaßen ausgestaltet, dass die Dioden D612 umgekehrt sind. Damit kann eine Diode 612 als Verbindungsmittel mit einem Verbindungs-Schaltsignal 621 in der High-Zeitspanne das Sensorelement C613 an die übrige Schaltung verbinden.

Somit zeichnet sich die Erfindung bzw. die vorstehend beschriebenen Schaltungen durch folgende Punkt aus:

Zum einen ist die Schaltung in Ansteuerteil, Auswerteteil und Signalzweigteil aufgeteilt. Die Anzahl der Signalzweige kann dabei im wesentlichen frei und mit einer größeren Anzahl gewählt werden, beispielsweise bis zu 20 Signalzweige bzw. Sensorelemente.

Von der Vielzahl der Sensorzweige 19 wird durch ein entsprechendes Verbindungs-Schaltsignal 21 und entsprechende Verbindungsmittel T12 oder D12 jeweils nur genau ein Sensorzweig mit einem Sensorelement C13 an die Ansteuerung und Auswertung angeschlossen. Damit kann eine Art Multiplexung auf sehr einfache Art und Weise erreicht werden. Über die Verschiebung des Spannungsgleichgewichts an dem Transistor T11 kann mit entsprechender Aufladung des Kondensators C11 im Auswerteteil ein analoges Ausgangssignal erzielt werden. Dieses Ausgangssignal kann ohne weitere Verstärkung von einem Controller oder dergleichen ausgewertet werden.

Die Möglichkeit der Variation der Anordnung und Ausgestaltung der Verbindungsschaltmittel sowie deren Ansteuerung durch Verbindungs-Schaltsignale ist durch die vorhergehende Beschreibung sowie die zugehörigen Schaltungsbeispiele für den Fachmann auch in allgemeiner Form verständlich und entsprechend ausführbar.

Des weiteren ist es möglich, die kapazitiven Sensorelemente C13 durch entsprechende andere Sensorelement, beispielsweise auf optischer Basis oder mittels Ultraschall, zu ersetzen und entsprechend an die Schaltung anzupassen.

Ein besonders großer Vorteil einer solchen Schaltungsanordnung liegt darin, dass Bauteile reduziert werden können zur Kostenersparnis und zur Sicherstellung einer zuverlässigen Funktion.

Gemäß einem Ausführungsbeispiel der Erfindung kann also eine Schaltungsanordnung für mehrere Sensorelemente von Berührungsschaltern geschaffen werden. Sie ist aufgeteilt in einen Ansteuerteil mit einem Ansteuersignal und einen Sensorteil mit mehreren Sensorzweigen, die jeweils ein kapazitives Sensorelement enthalten. Ein Auswerteteil weist unter anderem einen Kondensator auf, an dem ein analoges Ausgangssignal abgegriffen werden kann. Über Verbindungsmittel, beispielsweise in Form von Transistoren der Dioden, wird mit entsprechender Ansteuerung jeweils genau ein Sensorzweig an die übrige Schaltung angeschlossen und das entsprechende Sensorelement angesteuert und ausgewertet.

## Patentansprüche

1. Schaltungsanordnung (11) für mehrere Sensorelemente von Berührungsschaltern (C13), mit:
- einem Ansteuerteil (12) mit einer Signalquelle (13) zur Lieferung eines Ansteuersignals
- einem Sensorteil (18) mit den Sensorelementen und
- einem Auswerteteil (15) mit Auswertemitteln (T11, C11,R 12, 16),
wobei der Auswerteteil (15) einen Kondensator (C 11) und einen Transistor (T11) aufweist, wobei der Kollektor des Transistors über den Kondensator mit Masse verbunden ist, der Emitter des Transistors mit der Signalquelle zum Empfangen des Ansteuersignals (13) und die Basis des Transistors über eine Diode (D11) und einen Widerstand (R11) mit der Signalquelle zum Empfangen des Ansteuersignals verbunden ist, wobei über den Widerstand (R11) und die Diode (D11) bei einem unbetätigtem verbundenen Sensorelement ein Spannungsgleichgewicht zwischen der Basis und dem Emitter eingestellt ist, **dadurch gekennzeichnet, dass** Verbindungsmittel (T12; D112) vorgesehen sind zur wählbaren Verbindung eines Sensorelements mit dem Auswerteteil (15) zur Auswertung des Betätigungszustandes des Sensorelements.

2. Schaltungsanordnung nach Anspruch 1, **dadurch gekennzeichnet, dass** die Verbindungsmittel Halbleiterbauelemente sind, vorzugsweise Dioden (D112 a-c).

3. Schaltungsanordnung nach Anspruch 1 oder 2, **dadurch gekennzeichnet, dass** die Verbindungsmittel Schaltmittel bzw. Schalter sind, vorzugsweise elektronische ansteuerbare Schalter, insbesondere Transistoren (T12 a-c).

4. Schaltungsanordnung nach einem der vorhergehenden Ansprüche, **dadurch gekennzeichnet, dass** die Verbindungsmittel (T12; D112) über ein getaktetes Signal (13) ansteuerbar sind, wobei die Taktung des Signals derart ist, dass gemäss der Anzahl der Sensorelemente (C13) jeweils nur ein Sensorelement gleichzeitig über die Verbindungsmittel mit dem Auswerteteil (15) verbunden ist.

5. Schaltungsanordnung nach einem der vorhergehenden Ansprüche, **dadurch gekennzeichnet, dass** pro Sensorelement (C13) ein Verbindungsmittel (T12; D112) vorgesehen ist.

6. Schaltungsanordnung nach einem der vorhergehenden Ansprüche, **dadurch gekennzeichnet, dass** die Sensorelemente (C13) permanent mit dem Ansteuerteil (12) verbunden sind, vorzugsweise liegt das Ansteuersignal (13) ständig an den Sensorelementen (C13) an.

7. Schaltungsanordnung nach einem der vorhergehenden Ansprüche, **dadurch gekennzeichnet, dass** die Sensorelemente (C13) mittels der Verbindungsmittel (T12; D112) mit dem Ansteuerteil (12) bzw. dem Ansteuersignal (13) verbindbar sind, vorzugsweise entsprechend Anspruch 4 gleichzeitig mit dem Ansteuerteil und dem Auswerteteil (15).

8. Schaltungsanordnung nach einem der vorhergehenden Ansprüche, **dadurch gekennzeichnet, dass** der Auswerteteil (15) mit einem Controller zum Auslesen des Signals (16) verbunden ist.

9. Schaltungsanordnung nach Anspruch 1, **dadurch gekennzeichnet, dass** bei einer Betätigung des Sensorelements (C13) das Gleichgewicht zwischen Basis und Emitter des Transistors (T11) verändert wird und der Transistor daraufhin mehr öffnet und der Kondensator (C11) auf einen höheren Spannungswert aufgeladen wird, wobei vorzugsweise der Transistor als über seine Basis steuerbarer Widerstand arbeitet.

10. Schaltungsanordnung nach einem der vorhergehenden Ansprüche, **dadurch gekennzeichnet, dass** die Sensorelemente (C13) in Sensorzweigen (19) mit einem Ansteuerpunkt und einem Masseschluss enthalten sind, wobei der Ansteuerpunkt mit dem Ansteuersignal (13) und der Auswerteschaltung (15) verbunden ist und die Verbindungsmittel (T12; D112) in dem Sensorzweig (19) enthalten sind, insbesondere auch eine Ansteuerung (21) der Verbindungsmittel.

## Claims

1. Circuit layout (11) for several sensor elements of touch switches (C13), having:
- a control part (12) with a signal source (13) for supplying a control signal,
- a sensor part (18) with the sensor elements, and
- an evaluating part (15) with evaluating means (T11, C11, R12, 16),
in which the evaluating part (15) has a capacitor (C11) and a transistor (T11), the collector of the transistor being connected to earth across the capacitor, the emitter of the transistor being connected to the signal source for receiving the control signal and the base of the transistor is connected across a diode (D11) and a resistor (R11) to the signal source for receiving the control signal, a voltage equilibrium being set between the base and the emitter via resistor (R11) and diode (D11) in the case of an unoperated, connected sensor element, **characterized in that** connecting means (T12; D112) are provided for connecting, as desired, a sensor element to the evaluating part (15) for evaluating the operating state of the sensor element.

2. Circuit layout according to claim 1, **characterized in that** the connecting means are semiconductor components, preferably diodes (D112 a-c).

3. Circuit layout according to claim 1 or 2, **characterized in that** the connecting means are switching means or switches, preferably electronically controllable switches, particularly transistors (T12 a-c).

4. Circuit layout according to one of the preceding claims, **characterized in that** the connecting means (T12; D112) are controllable via a timed signal (13), the timing of the signal being such that in accordance with the number of sensor elements (C13) in each case only one sensor element is simultaneously connected via the connecting means to the evaluating part (15) .

5. Circuit layout according to one of the preceding claims, **characterized in that** there is one connecting means (T12; D112) per sensor element (C13).

6. Circuit layout according to one of the preceding claims, **characterized in that** the sensor elements (C13) are permanently connected to the control part (12), the control signal (13) being permanently applied to the sensor elements (C13).

7. Circuit layout according to one of the preceding claims, **characterized in that** the sensor elements (C13) are connectable by connecting means (T12; D112) to the control part (12) or the control signal (13) and preferably in accordance with claim 4, simultaneously to the control part and the evaluating part (15).

8. Circuit layout according to one of the preceding claims, **characterized in that** the evaluating part (15) is connected to a controller for reading out the signal (16).

9. Circuit layout according to claim 1, **characterized in that** on operating the sensor element (C13) there is a modification to the equilibrium between the emitter and base of transistor (T11) and then the transistor further opens and the capacitor (C11) is charged to a higher voltage value, the transistor preferably functioning as a resistor controllable across its base.

10. Circuit layout according to one of the preceding claims, **characterized in that** the sensor elements (C13) are contained in sensor branches (19) with a control point and a body contact, the control point being connected to the control signal (13) and the evaluating circuit (15) and the connecting means (T12; D112) are contained in the sensor branch (19), particularly also a control (21) of the connecting means.

## Revendications

1. Circuit (11) pour plusieurs éléments détecteur de commutateurs à effleurement (C13), comprenant :
- une unité de commande (12) avec une source de signaux (13) pour l'émission d'un signal de commande,
- une unité détecteur (18) présentant les éléments détecteur et
- une unité d'évaluation (15) présentant des moyens d'évaluation (T11, C11, R12, 16),
sachant que l'unité d'évaluation (15) présente un condensateur (C11) et un transistor (T11), sachant que le collecteur du transistor est raccordé à la masse au moyen du condensateur, que l'émetteur du transistor est raccordé à la source de signaux pour capter le signal de commande (13) et que la base du transistor est raccordée à la source de signaux pour capter le signal de commande au moyen d'une diode (D11) et d'une résistance (R11), sachant que quand l'élément détecteur est branché mais il n'est pas actionné s'établi un équilibre de tension entre la base et l'émetteur au moyen de la résistance (R11) et la diode (D11), **caractérisé en ce qu'**on prévoit des moyens de raccordement (T12 ; D112) pour le raccordement de sélection d'un élément détecteur à l'unité d'évaluation (15) pour l'évaluation de l'état d'actionnement de l'élément détecteur.

2. Circuit d'après la revendication 1, **caractérisé en ce que** les moyens de raccordement sont des composants électroniques à semiconducteurs, de préférence des diodes (D112 a-c).

3. Circuit d'après la revendication 1 ou 2, **caractérisé en ce que** les moyens de raccordement sont des moyens de commutation ou encore des commutateurs, de préférence des contacteurs électroniques à commander, notamment des transistors (T12 a-c).

4. Circuit d'après une des revendications précédentes, **caractérisé en ce que** les moyens de raccordement (T12 ; D112) peuvent être commandés par un signal synchronisé (13), sachant que la synchronisation du signal est telle que, selon le nombre d'éléments détecteur (C13), un seul élément détecteur est raccordé en même temps à l'unité d'évaluation (15) par les moyens de raccordement.

5. Circuit d'après une des revendications précédentes, **caractérisé en ce qu'**on prévoit un moyen de raccordement (T12 ; D112) par élément détecteur (C13).

6. Circuit d'après une des revendications précédentes, **caractérisé en ce que** les éléments détecteur (C13) sont toujours raccordés à l'unité d'évaluation (12), et que de préférence le signal de commande (13) est toujours appliqué aux éléments détecteur (C13).

7. Circuit d'après une des revendications précédentes, **caractérisé en ce que** les éléments détecteur (C13) peuvent être raccordés à l'unité de commande (12) ou encore au signal de commande (13) par les moyens de raccordement (T12 ; D112), de préférence d'après la revendication 4 à l'unité de commande en même temps qu'à l'unité d'évaluation (15).

8. Circuit d'après une des revendications précédentes, **caractérisé en ce que** l'unité d'évaluation (15) est raccordé à un controller pour la lecture du signal (16).

9. Circuit d'après la revendication 1, **caractérisé en ce que** l'équilibre entre la base et l'émetteur du transistor (T11) est modifié quand l'élément détecteur (C13) est actionné et que par conséquent le transistor (T11) s'ouvre un peu plus et le condensateur (C11) est chargé à une tension plus haute, sachant que de préférence le transistor est mis en oeuvre en tant que résistance qui peut être commandée par sa base.

10. Circuit d'après une des revendications précédentes, **caractérisé en ce que** les éléments détecteur (C13) sont compris dans des branches de détection (19) présentant un point de commande et un point de mise à la masse, sachant que le point de commande est raccordé au signal de commande (13) et au circuit d'évaluation (15) et que les moyens de raccordement (T12 ; D112) sont contenus dans la branche de détection (19), notamment aussi une commande (21) des moyens de raccordement.
